(19) Europäisches Patentamt
European Patent Office
Office européen des brevets

(11) **EP 3 736 588 B1**

(12) **EUROPÄISCHE PATENTSCHRIFT**

(45) Veröffentlichungstag und Bekanntmachung des Hinweises auf die Patenterteilung:
**21.06.2023 Patentblatt 2023/25**

(21) Anmeldenummer: **20173694.9**

(22) Anmeldetag: **08.05.2020**

(51) Internationale Patentklassifikation (IPC):
**G01R 31/3835** (2019.01)     **G01R 31/396** (2019.01)

(52) Gemeinsame Patentklassifikation (CPC):
**G01R 31/396; G01R 31/3835;** G01R 19/16542;
Y02E 60/10

(54) **EINHEIT, SYSTEM UND VERFAHREN ZUM ERMITTELN EINER ZELLSPANNUNG**

UNIT, SYSTEM AND METHOD FOR DETERMINATION OF CELL VOLTAGE

UNITÉ, SYSTÈME ET PROCÉDÉ DE DÉTERMINATION D'UNE TENSION DE CELLULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.05.2019 DE 102019206832**

(43) Veröffentlichungstag der Anmeldung:
**11.11.2020 Patentblatt 2020/46**

(73) Patentinhaber: **Viessmann Climate Solutions SE
35108 Allendorf (DE)**

(72) Erfinder: **KLEE, Hanspeter
35083 Wetter (DE)**

(74) Vertreter: **MERH-IP Matias Erny Reichl Hoffmann
Patentanwälte PartG mbB
Paul-Heyse-Strasse 29
80336 München (DE)**

(56) Entgegenhaltungen:
**WO-A1-94/07153          DE-A1-102013 012 148
US-A1- 2014 043 031**

**Beschreibung**

TECHNISCHES FELD

Die vorliegende Erfindung betrifft ein Verfahren zum Ermitteln einer Zellspannung und eine Einheit und ein System zum Ermitteln einer Zellspannung.

TECHNISCHES PROBLEM

In Zeiten der Elektromobilität spielen Energiespeicher, insbesondere wiederaufladbare Batterien, eine entscheidende Rolle in der technologischen Entwicklung. Dies führte bislang zur Entwicklung einer Vielzahl unterschiedlicher Batterietypen, wie z.B. Zink-Mangan-, Zink-Luft-, Quecksilber-Zink- oder Lithium-Ionen-Batterien.

Vor allem bei Lithium-Ionen-Batterien ist jedoch eine strikte Überwachung der Batterieeigenschaften, wie z.B. Zellspannungen, Temperatur, usw., notwendig, um die Batterien vor Schäden zu schützen.

In bisherigen Ausführungen eines Batteriemanagementsystems werden dabei die Zellspannungen derart gemessen, dass das Potential einer jeden Elektrode in Reihe geschalteter Batteriezellen der Batterie abgegriffen wird und an einen Chip zur Auswertung der Zellspannung weitergegeben wird. Dabei ist für jedes Potential ein Eingang am Chip notwendig. Im Chip wird die Zellspannung der Batteriezellen als die Differenz der Potentiale von den zwei Elektroden (Anode, Kathode) einer Batteriezelle ermittelt und über einen Analog-Digital-Umwandler digitalisiert. Durch Verwendung eines Multiplexers kann für alle Batteriezellen, die mit beiden Elektroden mit dem Chip verbunden sind, ein einziger Analog-Digital-Wandler verwendet werden.

Bei diesem Ansatz ist jedoch die Anzahl der Batteriezellen, die mittels eines einzigen Chips gemessen werden können, durch die Anzahl der Eingänge am Chip limitiert. Um auch für Hoch-Volt-Batteriesysteme, bei denen eine Vielzahl an Zellen in Reihe geschaltet sind, eine Überwachung der Zellspannungen zu ermöglichen, ist eine Kaskadierung von Chips notwendig. Dies führt jedoch zu erhöhten Kosten, da unter anderem Analog-Digital-Umwandler in jedem Chip und somit mehrfach verbaut werden.

Die WO 94/07153 A1 zeigt einen Apparat zur Überwachung der Spannung einer Batterie umfassend eine Mehrzahl an DC Versorgungseinheiten. Der Apparat beinhaltet einen Spannungsgenerator, wie einen Hochvolt-Verstärker, der eine sich über die Zeit verändernde Spannung erzeugt. Die Amplitude der sich über die Zeit verändernden Spannung ist zumindest so groß wie die Batteriespannung. Vergleichseinheiten werden dazu verwendet, an zu zeigen, wenn die sich verändernde Spannung eine vorbestimmte Funktion einer Spannung über zumindest eine der DC Versorgungseinheiten darstellt. Folglich kann die Spannung einer DC Versorgungseinheit überwacht werden, ohne dass die DC Versorgungseinheit mit einem Spannungsmeter verbunden wird. Da sich die vom Spannungsgenerator erzeugte Spannung über die Zeit ändert, stellt der Zeitpunkt, an dem die sich verändernde Spannung mit der vorbestimmten Funktion übereinstimmt, einen Wert der Spannung über die DC Versorgungseinheit dar.

Die DE 10 2013 012148 A1 zeigt eine Vorrichtung zum Erfassen einer von einer elektrischen Komponente bereitgestellten elektrischen Spannung mit einer Generatoreinrichtung zum Bereitstellen einer Referenzspannung, einer Messeinrichtung, die mit der Generatoreinrichtung und der elektrischen Komponente gekoppelt ist, zum Ermitteln eines Vergleichssignals anhand der mit der elektrischen Komponente bereitgestellten Spannung und der Referenzspannung und einer Auswerteeinrichtung, die mit der Messeinrichtung gekoppelt ist, zum Erfassen der von der elektrischen Komponente bereitgestellten Spannung anhand des Vergleichssignals, wobei die Generatoreinrichtung und die Auswerteeinrichtung galvanisch getrennt mit der Messeinrichtung gekoppelt sind.

Die US 2014/043031 A1 zeigt ein Verfahren und ein System, das zur Messung von elektrischen Spannungen in einer Batterie mit mehreren Batteriezellen eingerichtet ist. Eine Messschaltung beinhaltet zumindest einen Digital-Analog-Konverter, der zusammen mit mehreren Komparatoren einen Analog-Digital-Konverter zur Bestimmung der elektrischen Spannung der Batteriezellen bildet. Die Komparatoren vergleichen eine Referenzspannung, die durch den Analog-Digital-Konverter bereitgestellt wird, mit der elektrischen Spannung der Batteriezellen über mehrere verschiedene Messkanäle zu den einzelnen Batteriezellen.

Eine Aufgabe der Erfindung ist es, ein Verfahren und ein System zur einfachen und zweckdienlichen Ermittlung von Zellspannungen bereitzustellen.

LÖSUNG DES PROBLEMS

Die Aufgabe wird mit den Merkmalen der unabhängigen Ansprüche 1 und 7 gelöst. Die abhängigen Ansprüche sind auf besondere Ausführungsformen der Erfindung gerichtet.

Ein erfindungsgemäßes Verfahren zum Ermitteln eines Wertes einer Zellspannung $U_m$ umfasst einen Schritt Berechnen einer Zellspannung $U_m$ einer m-ten Zelle von in Reihe geschalteten Zellen auf Basis folgender Gleichung:

$$U_m = V_{n+1} - V_n,$$

wobei eine elektrische Spannung $V_n$ zwischen einem Referenzpotential P und einer ersten Elektrode der m-ten Zelle anliegt und eine elektrische Spannung $V_{n+1}$ zwischen dem Referenzpotential P und einer zweiten Elektrode der m-ten Zelle anliegt. Zellen im Rahmen dieser Erfindung können sowohl primäre, sekundäre als auch tertiäre galvanische Zellen sein, wie z.B. Batterien und Akkus, sowie Brennstoffzellen. Die Erfindung ist jedoch nicht auf galvanische Zellen beschränkt.

Da ein elektrisches Potential - das Referenzpotential P - bei allen Spannungsermittlungen verwendet wird, kann die Schaltung, bzw. der Schaltaufwand für die einzelnen Spannungsermittlungen deutlich minimiert werden. Dies hat den Vorteil, dass bei Verwendung eines Multiplexers die Komplexität der Schaltung des Multiplexers vereinfacht (alle Eingänge müssen nur noch auf einen Ausgang statt auf zwei Ausgängen durchgeschaltet werden können) und dadurch ein Multiplexer mit einer größeren Anzahl an Eingängen verwendet werden kann, was die Zellspannungs-Ermittlung von zusätzlichen Zellen mit einem einzigen Analog-Digital-Umwandler ermöglicht.

Des Weiteren umfasst das erfindungsgemäße Verfahren einen Schritt des Bereitstellens einer elektrischen Referenzspannung $V_{ref}$, die sich über die Zeit verändert, umfassen. Die elektrische Referenzspannung $V_{ref}$ kann sich dabei kontinuierlich oder zeitdiskret verändern. Mögliche Funktionen, die dem zeitlichen Verlauf der elektrischen Referenzspannung $V_{ref}$ entsprechen, sind beispielsweise eine linear steigende oder fallende Rampe, der Verlauf einer Exponentialfunktion, Funktionen die aus mehreren Funktionen zusammengesetzt sind, Funktionen mit Unstetigkeitsstellen, Funktionen, die durch Rauschen entstehen, oder beliebige andere Funktionen.

Weitere Schritte des erfindungsgemäßen Verfahrens sind das Vergleichen der elektrischen Referenzspannung $V_{ref}$ mit den elektrischen Spannungen $V_n$ und $V_{n+1}$, z.B. mittels eines Komparators, und das Ausgeben von einem ersten Signal S1, wenn die elektrische Referenzspannung $V_{ref}$ wertemäßig den Wert der elektrischen Spannung $V_n$ erreicht, sein. Das Signal S1 könnte beispielsweise dabei unter anderem ein Interrupt Signal, ein Dirac-Impuls, ein Codiertes Signal, eine Sprungantwort, usw. sein, gemäß der Erfindung ist das Signal S1 aber ein Interrupt Signal. Durch Ausgeben des Signals S1, wird eine Erfassung des Zeitpunktes, an dem die elektrische Referenzspannung $V_{ref}$ mit der ersten elektrischen Spannung $V_n$ übereinstimmt, ermöglicht.

Ein weiterer Schritt kann das Ermitteln des Wertes der elektrischen Spannung $V_n$ mittels des Signals S1 sein. Ein mögliches Vorgehen zum Ermitteln der elektrischen Spannung $V_n$ ist das Auswerten der elektrischen Referenzspannung $V_{ref}$ zu dem Zeitpunkt an dem das Signal S1 ausgegeben wird, z.B. mit einem Analog-Digital-Wandler.

Weitere mögliche Schritte sind Ausgeben von einem zweiten Signal S2, wenn die elektrische Referenzspannung $V_{ref}$ wertemäßig den Wert der elektrischen Spannung $V_{n+1}$ erreicht, und das Ermitteln des Wertes der elektrischen Spannung $V_{n+1}$ mittels des Signals S2. Das Signal S2 könnte beispielsweise ebenfalls wie das Signal S1 unter anderem ein Interrupt Signal, ein Dirac-Impuls, ein Codiertes Signal, eine Sprungantwort, usw. sein, gemäß der Erfindung ist das Signal S2 aber ein Interrupt Signal. Das Vorgehen zur Ermittlung der elektrischen Spannung $V_{n+1}$ kann dabei mit dem Vorgehen zur Ermittlung der elektrischen Spannung $V_n$ übereinstimmen. Die elektrische Spannung $V_{n+1}$ kann aber auch mit einem weiteren Verfahren, das sich vom Verfahren zur Ermittlung der elektrischen Spannung $V_n$ unterscheidet, ermittelt werden.

Ein Vorteil bei einer solchen Ausführungsform des erfindungsgemäßen Verfahrens liegt unter anderem darin, dass alle Zellspannungsermittlungen an einem einzigen Punkt, ohne dass ein Multiplexer oder Schalter (analog oder digital) verwendet wird, ermittelt werden können.

Weiter ist das Verfahren gegenüber herkömmlichen Verfahren bei der Zellspannungsermittlung von in Reihe geschalteten Zellen nicht im Bezug auf die Anzahl der Zellen limitiert.

Bei einer bevorzugten Ausführungsform der Erfindung entspricht der zeitliche Verlauf der elektrischen Referenzspannung $V_{ref}$ einer vorgegebenen Funktion. Weiter werden die zu ermittelnden Werte der elektrischen Spannungen $V_n$ und/oder $V_{n+1}$ auf Basis der vorgegebenen Funktion der elektrischen Referenzspannung $V_{ref}$ und der Zeitpunkte, zu denen die Signale S1 und/oder S2 ausgegeben werden, berechnet.

Bei dieser Ausführungsform kann auf einen Analog-Digital-Umwandler verzichtet werden und die elektrischen Spannungen $V_n$ und/oder $V_{n+1}$ werden einzig mit dem Wissen über die zeitliche Änderung der Referenzspannung $V_{ref}$ und dem Zeitpunkt, zu dem die elektrische Referenzspannung $V_{ref}$ mit einer der elektrischen Spannung $V_n$ oder $V_{n+1}$ übereinstimmt, ermittelt. Dadurch können die Bauteilkosten deutlich minimiert werden. Ein Beispiel dafür wäre eine Ausführungsform mit einem Rampengenerator mit einer Rampensteigung von 2V/s und einer Ausgangsspannung von 0V zum Zeitpunkt t=0. Daraus lässt sich zum Beispiel ermitteln, dass bei Ausgabe eines Signals S1 zum Zeitpunkt t=5s die Spannung $V_n$ = 2V/s*5s = 10V beträgt.

Bei einer weiteren bevorzugten Ausführungsform der Erfindung werden die zu ermittelnden Werte der elektrischen Spannungen $V_n$ und/oder $V_{n+1}$ durch Ermitteln der elektrischen Referenzspannung $V_{ref}$ mit einem Analog-Digital-Umwandler zu den Zeitpunkten, zu denen die Signale S1 und/oder S2 ausgegeben werden, bestimmt. Dadurch kann die Genauigkeit des ermittelten Wertes für die Spannungen $V_n$, bzw. $V_{n+1}$ gegenüber der zuvor beschriebenen Ausführungsform verbessert werden, da Abweichungen in der Referenzspannung, z.B. auf Grund von nicht-linearen Bauteilen eines Signalgenerators, der die Referenzspannung bereitstellt, bei der Ermittlung der elektrischen Spannungen $V_n$ und/oder $V_{n+1}$ mit berücksichtig werden.

Bei einer weiteren bevorzugten erfindungsgemäßen Ausführungsform wird die elektrische Referenzspannung $V_{ref}$ mittels eines Digital-Analog-Umwandlers bereitgestellt, und die zu ermittelnden Werte der elektrischen Spannungen $V_n$ und/oder $V_{n+1}$ liegen am Eingang des Digital-Analog-Umwandlers in digitaler Form zu den Zeitpunkten, zu denen die Signale S1 und/oder S2 ausgegeben werden, an. Dies hat den Vorteil, dass der Signalgenerator und die Spannungs-Ermittlungs-Einheit mit einem Bauteil realisiert werden können.

Gemäß dem erfindungsgemäßen Verfahren sind die Signale S1 und S2 Interrupt Signale und werden über eine gemeinsame Signalleitung ausgegeben. Dies hat den Vorteil, dass weniger Signalleitungen benötigt werden und die Anzahl der nötigen Eingänge zur Auswertung der Signale S1 und/oder S2 beschränkt sich gegebenenfalls auf einen Eingang für die Signale S1 und S2. Folglich können uneingeschränkt viele Signale mit einer Spannungs-Ermittlungs-Einheit verarbeitet werden.

Eine vorteilhafte Weiterbildung umfasst den Schritt Aktivieren eines parallel zur m-ten Zelle geschalteten Balancers bei Vorliegen eines Steuersignals SB und der Signale S1 und/oder S2. Somit kann der Balancer direkt nach dem Ermittlungsvorgang automatisch bei Vorliegen des Steuersignals SB aktiviert werden. Dadurch kann die Nutzung der Zellkapazitäten bei gleichzeitig optimalem Schutz der Zellen verbessert werden.

Eine vorteilhafte Weiterbildung umfasst den Schritt Deaktivieren eines parallel zur m-ten Zelle geschalteten Balancers bei Ausbleiben eines Steuersignals SB. Dies ermöglicht eine einfache Deaktivierung eines einzigen, von mehreren oder allen Balancern.

In den gezeigten Ausführungsformen und Weiterbildungen des erfindungsgemäßen Verfahrens können Schritte zusammengefasst, getrennt, parallelisiert und/oder zusätzliche Schritte hinzugefügt werden ohne den Umfang der Erfindung einzuschränken.

Ein erfindungsgemäßes System zum Erfassen einer Zellspannung umfasst einen Signalgenerator zum Bereitstellen einer elektrischen Referenzspannung $V_{ref}$, die sich über die Zeit verändert, zwei Komparatoren zum Vergleichen der elektrischen Referenzspannung $V_{ref}$ mit den elektrischen Spannungen $V_n$ und $V_{n+1}$, wobei ein erster Komparator ein erstes Signal S1 ausgibt, wenn die elektrische Referenzspannung $V_{ref}$ wertemäßig den Wert der elektrischen Spannung $V_n$ erreicht und ein zweiter Komparator ein zweites Signal S2 ausgibt, wenn die elektrische Referenzspannung $V_{ref}$ wertemäßig den Wert der elektrischen Spannung $V_{n+1}$ erreicht.

Dabei kann der Signalgenerator z.B. ein Rampengenerator, ein Rausch-Generator, ein Digital-Analog-Umwandler, ein CW-Generator oder ein Signalgenerator zur Ausgabe eines beliebigen Signals, usw. sein. Außerdem kann bei Ausführungsformen der Signalgenerator von einem externen Gerät gesteuert werden oder aber selbständig das Signal generieren. Die Art des ausgegebenen Signals des Signalgenerators ist vorzugsweise eine Spannung. Zusätzlich umfasst das erfindungsgemäße System eine Spannungs-Ermittlungs-Einheit zum Ermitteln des Wertes der elektrischen Spannung $V_n$ mittels des Signals S1 und zum Ermitteln des Wertes der elektrischen Spannung $V_{n+1}$ mittels des Signals S2. Die Spannungs-Ermittlungs-Einheit kann beispielsweise in Form eines Analog-Digital-Umwandlers realisiert sein. Zudem umfasst das erfindungsgemäße System eine Spannungs-Berechnungseinheit, die zum Ermitteln eines Wertes einer Zellspannung $U_m$ einer m-ten Zelle von in Reihe geschalteten Zellen auf Basis folgender Gleichung: $U_m = V_{n+1} - V_n$ eingerichtet ist, wobei die elektrische Spannung $V_n$ zwischen einem Referenzpotential P und einer ersten Elektrode der m-ten Zelle anliegt und die elektrische Spannung $V_{n+1}$ zwischen dem Referenzpotential P und einer zweiten Elektrode der m-ten Zelle anliegt. Die Signale S1 und S2 sind Interrupt Signale und werden über eine gemeinsame Signalleitung ausgegeben.

Bei einer besonders vorteilhaften Ausführungsform des erfindungsgemäßen Systems entspricht der zeitliche Verlauf der elektrischen Referenzspannung $V_{ref}$ einer vorgegebenen Funktion, und die zu ermittelnden Werte der elektrischen Spannungen $V_n$ und/oder $V_{n+1}$ werden auf Basis der vorgegebenen Funktion der elektrischen Referenzspannung $V_{ref}$ und der Zeitpunkte, zu denen die Signale S1 und/oder S2 ausgegeben werden, berechnet.

Bei einer weiteren möglichen Ausführungsform des erfindungsgemäßen Systems werden die zu ermittelnden Werte der elektrischen Spannungen $V_n$ und/oder $V_{n+1}$ durch Ermitteln der elektrischen Referenzspannung $V_{ref}$ mittels eines Analog-Digital-Umwandlers zu den Zeitpunkten, zu denen die Signale S1 und/oder S2 ausgegeben werden, bestimmt.

Bei einer vorteilhaften Weiterbildung des erfindungsgemäßen Systems wird die elektrische Referenzspannung $V_{ref}$ mittels eines Digital-Analog-Umwandlers bereitgestellt und liegen die zu ermittelnden Werte der elektrischen Spannungen $V_n$ und/oder $V_{n+1}$ am Eingang des Digital-Analog-Umwandlers in digitaler Form zu den Zeitpunkten, zu denen die Signale S1 und/oder S2 ausgegeben werden, an. Der Digital-Analog-Umwandler ist in diesem Fall sowohl Signalgenerator als auch Spannungs-Ermittlungs-Einheit, wobei für die Spannungs-Ermittlung kein weiterer Aufwand betrieben werden muss, da der Wert bereits in der gewünschten Form vorliegt.

Eine vorteilhafte Weiterbildung des erfindungsgemäßen Systems umfasst einen parallel zur m-ten Zelle geschalteten Balancer, der bei Vorliegen eines Steuersignals SB und der Signale S1 und/oder S2 aktiviert und bei Ausbleiben des Steuersignals SB deaktiviert wird.

Bei einer vorteilhaften Weiterbildung des erfindungsgemäßen Systems sind die Ausgänge mindestens zweier Komparatoren über eine Signalleitung mit der Spannungs-Ermittlungs-Einheit verbunden. Dies hat den Vorteil, dass die Anzahl der Zellen, deren Spannungen ermittelt werden sollen, nicht durch fehlende Eingänge an der Spannungs-Ermittlungs-Einheit begrenzt ist.

Bei einer vorteilhaften Ausführungsform des erfindungsgemäßen Systems ordnet die Spannungs-Ermittlungs-Einheit die Signale S1 und/oder S2 basierend auf der zeitlichen Reihenfolge, in der die Signale S1 und S2 ausgegeben werden, den Elektroden der Zellen zu. Dies hat den Vorteil, dass keine weiteren Berechnungen und/oder Operationen, wie z.B. Vergleichen zweier Spannungswerte, notwendig sind.

Bei einer besonders vorteilhaften Ausführungsform des erfindungsgemäßen Systems sind die Signale S1 und/oder S2 codiert und ordnet die Spannungs-Berechnungs-Einheit die Signale S1 und/oder S2 anhand der Codierung den Elektroden der Zellen zu. Mögliche Codierungen sind sowohl analoge als auch digitale Codierungen, wie z.B. mittels Phase-Shift-Keying oder mittels Verwendens von digitalen Codewörtern für die Signale S1 und/oder S2. Dadurch kann ein vom Hersteller ungewünschter Austausch von einzelnen Zellen oder der ganzen Zellanordnung durch Zellen von Drittanbietern verhindert werden.

Bei einer vorteilhaften Ausführungsform des erfindungsgemäßen Systems entspricht der zeitliche Verlauf der elektrischen Referenzspannung $V_{ref}$ einer monoton steigenden oder monoton fallenden Funktion und ordnet die Spannungs-Ermittlungs-Einheit die Signale S1 und/oder S2 anhand der elektrischen Spannungswerte $V_n$ und/oder $V_{n+1}$ den Elektroden der Zellen zu. Da die Spannungswerte $V_n$ bzw. $V_{n+1}$ je nach Aufbau vom Referenzpotential P weg größer bzw. kleiner werden, lassen sich die Werte über deren Größe den Elektroden zuordnen.

Bei einer vorteilhaften Ausführungsform des erfindungsgemäßen Systems ist mindestens eine Signalleitung einem einzigen Komparator zur Signalübertragung des Signals S1 oder S2 zur Spannungs-Ermittlungs-Einheit zugeordnet und ordnet die Spannungs-Ermittlungs-Einheit die Signale S1 und /oder S2 den Elektroden der Zellen basierend auf die verwendeten Signaleingänge bei der Spannungs-Ermittlungs-Einheit zu.

In manchen Ausführungsformen beinhaltet das System Zellen, deren Zellspannungen zu ermitteln/messen sind. In manchen Ausführungsformen, beinhaltet das System keine Zellen, deren Zellspannungen zu ermitteln/messen sind, wobei das System jedoch dazu eingerichtet ist Zellspannungen zu ermitteln.

Systemkomponenten dieser Erfindung können, ohne den Umfang der Erfindung zu beeinflussen, aufgeteilt, zusammengefasst, sowie aufgeteilt und anderweitig zusammengefasst werden. Ebenso ist die Einbettung in ein anderes System, sowie eine Erweiterung des Systems ohne Einfluss auf den Umfang der Erfindung möglich. Außerdem können einzelne Systemkomponenten als Software-Module, die auf einer Recheneinheit ausgeführt werden, ausgeführt sein.

Weitere Vorteile, Komponenten und mögliche Konfigurationen und Abläufe der Erfindung werden anhand der folgenden Beschreibungen bevorzugter Ausführungsbeispiele ersichtlich.

## KURZE BESCHREIBUNG DER FIGUREN

Figur 1 zeigt schematisch ein System zum Ermitteln einer Zellspannungen gemäß einer Ausführungsform.

Figur 2 zeigt schematisch einen Prozessfluss zum Ermitteln einer Zellspannung gemäß einer Ausführungsform.

Figur 3 zeigt ein Beispiel für mehrere in Reihe geschaltete Zellen.

Figur 4 zeigt schematisch ein System gemäß einem nicht beanspruchten Beispiel.

Figur 5 zeigt schematisch ein System gemäß einem weiteren nicht beanspruchten Beispiel.

Figur 6 zeigt schematisch einen Prozessfluss zum Ermitteln einer Zellspannung gemäß einer weiteren Ausführungsform.

Figur 7 zeigt schematisch ein System gemäß einer weiteren Ausführungsform.

Figur 8 zeigt schematisch einen Teil eines Systems bei Verwendung eines Balancers RB gemäß einer Ausführungsform.

Figuren 9 und 10 zeigen mögliche Schaltpläne zum Aktivieren und Deaktivieren eines Balancers RB gemäß einer Ausführungsform.

Figur 11 zeigt beispielhafte Verläufe der Referenzspannung $V_{ref}$ und der Spannungen $V_n$ und $V_{n+1}$.

## DETAILLIERTE BESCHREIBUNG DER FIGUREN UND BEVORZUGTER AUSFÜHRUNGSBEISPIELE

Im Folgenden werden Beispiele bzw. Ausführungsbeispiele der vorliegenden Erfindung detailliert unter Bezugnahme auf die beigefügten Figuren beschrieben. Gleiche Elemente in den Figuren können hierbei mit gleichen Bezugszeichen bezeichnet sein.

Es sei hervorgehoben, dass die vorliegende Erfindung jedoch in keiner Weise auf die im Folgenden beschriebenen Ausführungsbeispiele und deren Ausführungsmerkmale begrenzt bzw. eingeschränkt ist, sondern weiterhin Modifikationen der Ausführungsbeispiele umfasst, insbesondere diejenigen, die durch Modifikation der Merkmale der beschriebenen Beispiele bzw. durch Kombination einzelner oder mehrere Merkmale der beschriebenen Beispiele im Rahmen des Schutzumfanges der unabhängigen Ansprüche umfasst sind.

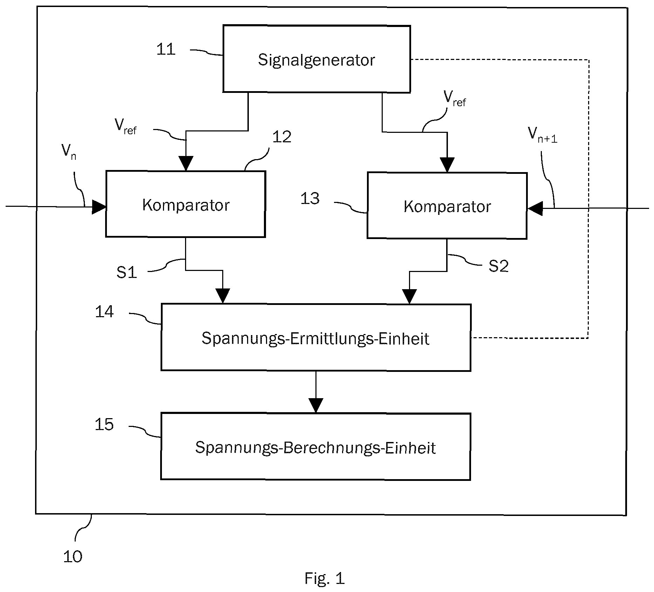

Figur 1 zeigt schematisch ein System 10 zum Ermitteln einer Zellspannung gemäß einer Ausführungsform der Erfindung. Das System 10 umfasst einen Signalgenerator 11, Komparatoren 12, 13, eine Spannungs-Ermittlungs-Einheit 14 und eine Spannungs-Berechnungs-Einheit. Das System ist in seiner Ausführungsform besonders dafür geeignet Zellspannungen einer Batterie zu ermitteln, insbesondere von Lithium-Ionen-Batterien. Das System ist jedoch in keiner Weise auf Lithium-Ionen-Batterien beschränkt, sondern ist vielmehr darauf ausgelegt Zellspannungen in Reihe geschalteter Zellen auf eine kostengünstige Weise zu ermitteln. Je nach Ausführungsform können Komponenten des Systems zu einem System zusammengefasst oder eine Komponente in mehrere Komponenten aufgeteilt werden. Außerdem können einzelne Einheiten als Software-Module, die auf einer Recheneinheit laufen, ausgeführt sein.

Ein Signalgenerator 11 erzeugt dabei eine elektrische Referenzspannung $V_{ref}$, die sich über die Zeit verändert. Mögliche Ausführungsformen eines Signalgenerators sind ein Rampengenerator, der z.B. mittels eines Integrierers und eines Schalters kostengünstig implementiert werden kann, ein Digital-Analog-Umwandler, der eine digitale Information, z.B. eine Bitfolge, analog als elektrische Spannung ausgibt, usw. Der zeitliche Verlauf der elektrischen Referenzspannung $V_{ref}$ entspricht möglicherweise einer vorgegebenen Funktion, die aus vielen und unstetigen Funktionen zusammengesetzt sein kann, oder ist zufälliger Natur.

Die Komparatoren 12, 13 vergleichen die vom Signalgenerator 11 ausgegebene elektrische Referenzspannung $V_{ref}$ mit einer Spannung $V_n$, die zwischen einem Referenzpotential P und einer ersten Elektrode einer m-ten Zelle anliegt, bzw. mit einer Spannung $V_{n+1}$, die zwischen dem Referenzpotential P und einer zweiten Elektrode der m-ten Zelle anliegt und geben ein Signal S1 bzw. S2 aus, wenn die Referenzspannung $V_{ref}$ wertemäßig den Wert der elektrischen Spannung $V_n$, bzw. $V_{n+1}$ erreicht, übersteigt oder untersteigt. Das Referenzpotential P kann an einem Ende der in Reihe geschalteten Zellen sein, zwischen zwei Zellen der in Reihe geschalteten Zellen oder ein mittels einer Schaltung zu den in Reihe geschalteten Zellen verbundener Punkt sein, sodass die Spannungen $V_n$ und $V_{n+1}$ endlich sind, d.h. dass sie einen beliebigen Wert annehmen.

Die Spannungs-Ermittlungs-Einheit 14 ermittelt basierend auf dem Zeitpunkt, an dem S1; S2 ausgegeben wurde, die Werte der Spannung $V_n$; $V_{n+1}$. Die Werte der Spannungen $V_n$; $V_{n+1}$ können je nach Ausführungsform durch Abgreifen der elektrischen Referenzspannung $V_{ref}$ mit einem Analog-Digital-Umwandler, durch Berechnen mittels des Zeitpunkts, an dem Signal S1; S2 ausgegeben wurde, und dem Verlauf der Spannung $V_{ref}$, usw. ermittelt werden.

Die Spannungs-Berechnungs-Einheit 15 berechnet den Wert der Zellspannung $U_m$ der m-ten Zelle auf Basis der von der Spannungs-Ermittlungs-Einheit 14 ermittelten Werte der Spannungen $V_n$ und $V_{n+1}$ mit der Gleichung $U_m = V_{n+1} - V_n$.

Die dargestellten Verbindungen zwischen den Komponenten/Einheiten schließen weitere Verbindungen zwischen Komponenten/Einheiten nicht aus.

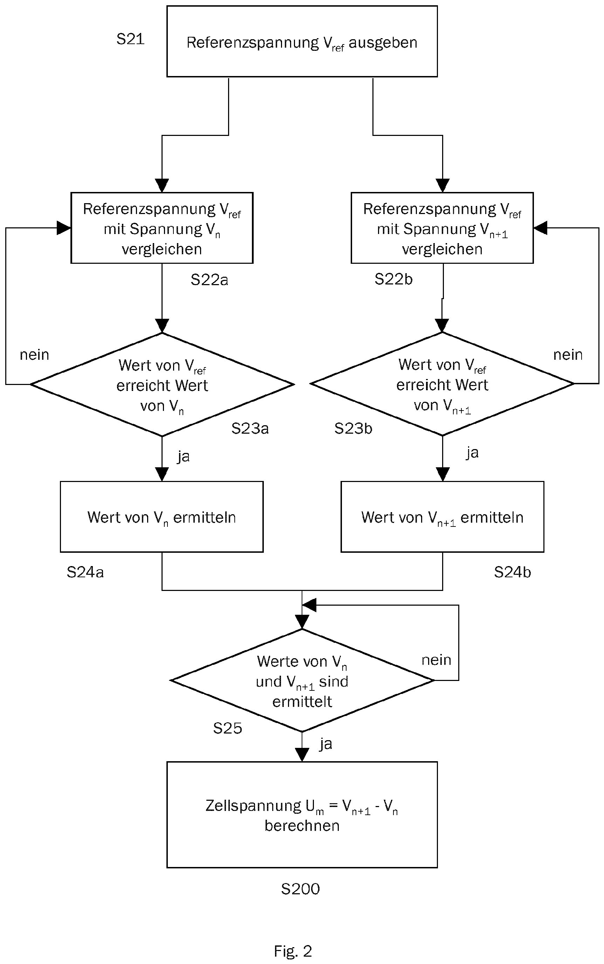

Figur 2 zeigt beispielhaft ein Ablaufdiagramm eines Verfahrens zum Ermitteln einer Zellspannung gemäß einem Ausführungsbeispiel. In einem ersten Schritt S21 wird eine Referenzspannung $V_{ref}$, die sich zeitlich verändert, zur Verfügung gestellt. Der Wertebereich der elektrischen Referenzspannung $V_{ref}$ umfasst vorzugsweise mindestens die maximale Spannung, die in Summe über alle in Reihe geschalteten Zellen anliegen kann. Je nach Festlegung des Referenzpotentials P, kann es vorteilhaft sein den Wertebereich der elektrischen Referenzspannung $V_{ref}$ durch Hinzufügen eines Offset-Wertes zu verändern.

Die elektrische Referenzspannung $V_{ref}$ wird in einem zweiten Schritt 22a mit einer Spannung $V_n$, die zwischen einem Referenzpotential P und einer ersten Elektrode einer m-ten Zelle anliegt, verglichen. In einem weiteren Schritt S23a wird basierend auf dem Vergleich im Schritt S22a eine Fallunterscheidung vorgenommen. Ist der Wert der Spannung $V_n$ wertemäßig von der elektrischen Referenzspannung $V_{ref}$ erreicht, wird mit einem Schritt S24a fortgefahren, andernfalls wird zu Schritt S22a zurückgekehrt.

Im Schritt S24a wird der Wert der Spannung $V_n$ ermittelt. Dies kann mit Hilfe der elektrischen Referenzspannung $V_{ref}$ und einem Analog-Digital-Umwandler geschehen, kann aber auch z.B. basierend auf den zeitlichen Verlauf der Referenzspannung $V_{ref}$, dem Zeitpunkt, zu dem der Wert von $V_n$ ermittelt wird, und Berechnungen oder mittels eines anderen Verfahrens ermittelt werden.

Analog zu den Schritten S22a, S23a und S24a werden die Schritte S22b, S23b, S24b anhand einer Spannung $V_{n+1}$, die zwischen dem Referenzpotential P und einer zweiten Elektrode der m-ten Zelle anliegt, ausgeführt.

In einem Schritt S25 wird sichergestellt, dass sowohl der Wert der Spannung $V_n$, als auch der Wert der Spannung $V_{n+1}$ vorliegt. Liegen die Werte beider Spannungen $V_n$ und $V_{n+1}$ vor, wird die Zellspannung $U_m$ mittels der Gleichung $U_m = V_{n+1} - V_n$ berechnet.

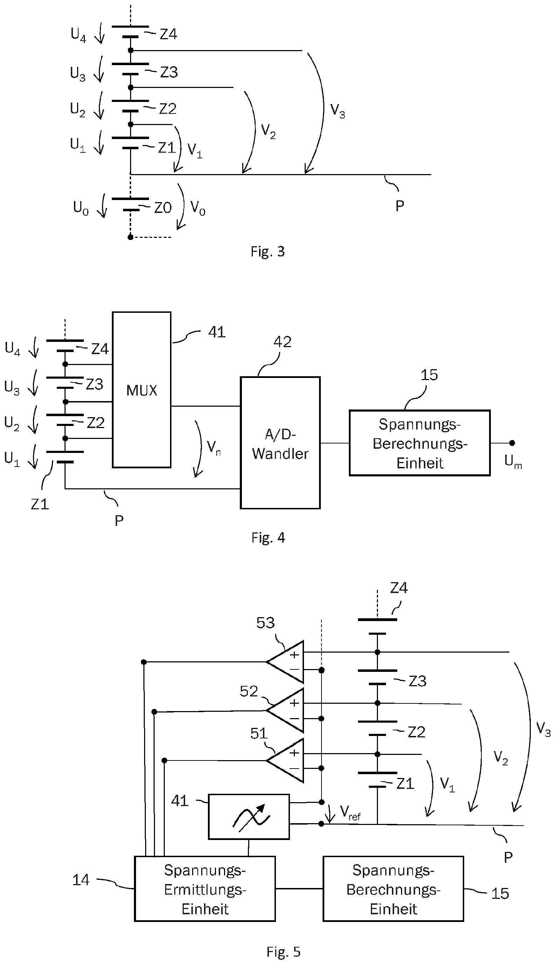

In Figur 3 werden in Reihe geschaltete Batteriezellen Z0, Z1, Z2, Z3, Z4 mit den dazugehörigen Zellspannungen $U_0, U_1, U_2, U_3, U_4$ und den Spannungen $V_0, V_1, V_2, V_3$, die zwischen einem Referenzpotential P und den Elektroden der Batteriezellen anliegen, gezeigt. Hierbei ist ersichtlich, dass das Referenzpotential P nicht an einem Ende der in Reihe geschalteten Zellen sein muss, vorteilhafterweise jedoch direkt mit einer Elektrode der Batteriezellen verbunden ist.

Dies hat den Vorteil, dass der Wertebereich der elektrischen Referenzspannung $V_{ref}$ von 0 V bis über die maximale Spannung der Batterie $V_{Bat,max}$ hinaus näherungsweise in einen Bereich von - $V_{Bat,max}/2$ und $V_{Bat,max}/2$ verschoben werden kann. Als Resultat wird die betragsmäßige Maximalspannung der elektrischen Referenzspannung $V_{ref}$ niedriger, wodurch die Ansprüche an die Spannungsfestigkeit der Kabel und einiger Bauteile verringert werden können. Weiterhin kann dadurch je nach Ausführungsform der erforderliche Spannungs-Ermittlungs-Bereich/Messbereich der Spannungs-Ermittlungs-Einheit 14 durch Vertauschen der Eingänge der Spannungs-Ermittlungs-Einheit verringert werden.

In Figur 4 ist ein Beispiel eines nicht beanspruchten Systems zu sehen. Zellen Z1, Z2, Z3, Z4 sind dabei über ihre Elektroden mit einem Multiplexer 41 verbunden. Der Multiplexer 41 ist wiederum mit einem Analog-Digital-Umwandler 42 (Spannungs-Ermittlungs-Einheit 14) verbunden. Der Digitale Ausgang des Analog-Digital-Umwandlers 42 ist wiederum mit der Spannungs-Berechnungs-Einheit 15 verbunden. Der Multiplexer 41 schaltet dabei jeweils ein Potential der Elektroden, das an einem der Eingänge anliegt an den Analog-Digital-Umwandler 42 durch. Ein zweiter Eingang des Analog-Digital-Umwandlers 42 ist fest mit einem Referenzpotential P verbunden. Der Analog-Digital-Umwandler 42 digitalisiert somit die Spannungswerte $V_n$, die am Eingang des Analog-Digital-Umwandlers 42 anliegen.

Die Spannungs-Berechnungs-Einheit 15 ermittelt die Werte der Zellspannung $U_m$ der m-ten Zelle mittels der ermittelten Spannungswerte $V_n$ mit der Gleichung $U_m = V_{n+1} - V_n$, wobei die Spannung $V_n$, bzw. $V_{n+1}$ zwischen verschiedenen Elektroden der m-ten Zelle und dem Referenzpotential P anliegen. Diese Ausführungsform hat den Vorteil, dass die Komplexität der Schaltung des Multiplexers 41 erheblich verringert werden kann und dadurch von einem Multiplexer 41 eine größere Anzahl an Zellpotentialen an den Analog-Digital-Umwandler 42 durchgeschaltet werden kann. Somit können die Spannungen von einer größeren Anzahl Zellen ermittelt werden.

In Figur 5 ist ein weiteres Beispiel eines nicht beanspruchten Systems gezeigt. Ein Komparator 51; 52; 53 vergleichen eine elektrische Referenzspannung $V_{ref}$, die von einem Signalgenerator 11 bereitgestellt wird, mit einer Spannungen $V_1$; $V_2$; $V_3$, die zwischen Elektroden von in Reihe geschalteten Zellen und einem Referenzpotential P anliegen. Der Signalgenerator 11 ist in dieser Ausführungsform beispielsweise ein Digital-Analog-Umwandler, der gesteuert von der Spannungs-Ermittlungs-Einheit 14 die elektrische Referenzspannung $V_{ref}$ bereitstellt.

Erreicht oder übersteigt die elektrische Referenzspannung $V_{ref}$ einen der Spannungswerte $V_1$; $V_2$; $V_3$; so gibt der jeweilige Komparator 51; 52; 53 ein Signal S1; S2; S3 an die Spannungs-Ermittlungs-Einheit 14 aus. Das Signal S1; S2; S3 kann in diesem Anwendungsbeispiel beispielsweise ein konstanter Spannungswert sein, der solange ausgegeben wird, bis der Wert der elektrischen Referenzspannung $V_{ref}$ wieder unter dem jeweiligem Spannungswert V1; V2; V3 liegt.

Die Spannungs-Ermittlungs-Einheit 14 ermittelt den Spannungswerte V1; V2; V3 anhand des Zeitpunktes, an dem von einem jeweiligen Komparator ein Signal S1; S2; S3 ausgegeben wird, und anhand des Steuersignals an den Signalgenerator 11 (Digital-Analog-Umwandler). Die Spannungs-Berechnungs-Einheit 15 berechnet basierend auf den Spannungswerten $V_1$, $V_2$, $V_3$ die Zellspannungen $U_1$, $U_2$, $U_3$ der in Reihe geschalteten Batteriezellen Z1, Z2, Z3. Um die Genauigkeit der ermittelten Zellspannungen zu verbessern, sowie die Dauer der Spannungs-Ermittlung zu verkürzen, kann es vorteilhaft sein, den Verlauf der elektrischen Referenzspannung $V_{ref}$ basierend auf vorhergehende Ergebnisse anzupassen.

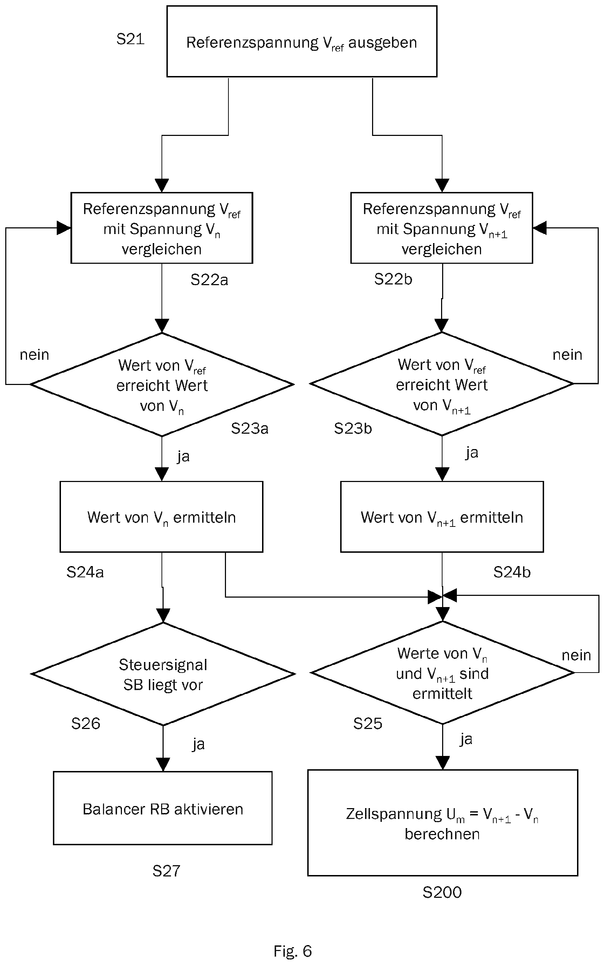

Figur 6 zeigt beispielhaft ein Ablaufdiagramm eines Verfahrens zum Ermitteln von Zellspannungen gemäß einem Ausführungsbeispiel basierend auf dem Ablaufdiagramm von Figur 2. Im Ablaufdiagramm der Figur 6 wurden zwei Schritte S26 und S27 gegenüber des Ablaufdiagrams von Figur 2 ergänzt. In dem Schritt S24a wird in diesem Ausführungsbeispiel nicht nur Schritt S25 aufgerufen, sondern auch Schritt S26. Im Schritt S26 wird überprüft ob ein Steuersignal SB vorliegt. Bei positivem Ergebnis wird ein weiterer Schritt S27, die Aktivierung eines Balancers RB, ausgeführt.

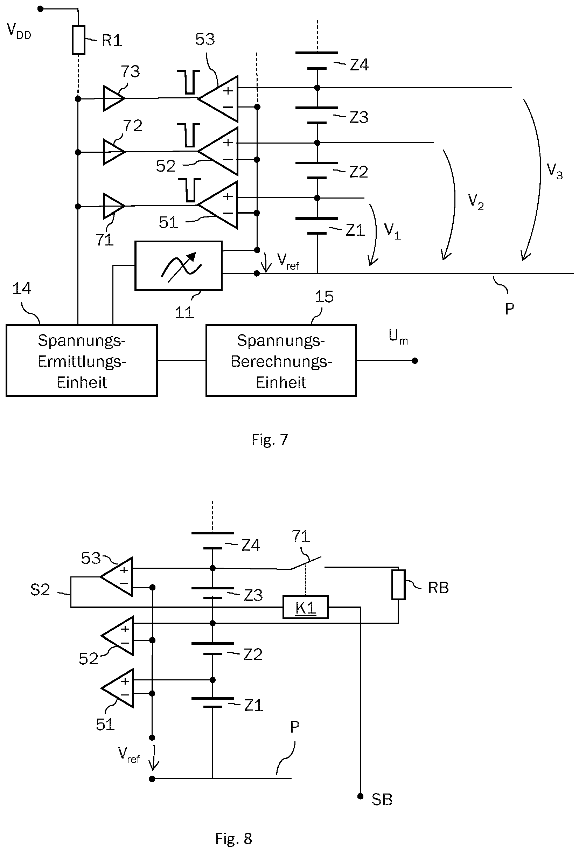

Figur 7 zeigt ein weiteres Ausführungsbeispiel gemäß der Erfindung. Komparatoren 51, 52, 53 vergleichen eine sich zeitlich verändernde elektrische Referenzspannung $V_{ref}$, die von einem Signalgenerator 11 erzeugt wird, mit Spannungen $V_1$, $V_2$, $V_3$, die zwischen Elektroden von in Reihe geschalteten Zellen und einem Referenzpotential P anliegen. Die Zellen können unter anderem beispielsweis Batteriezellen einer Lithium-Ionen Batterie sein.

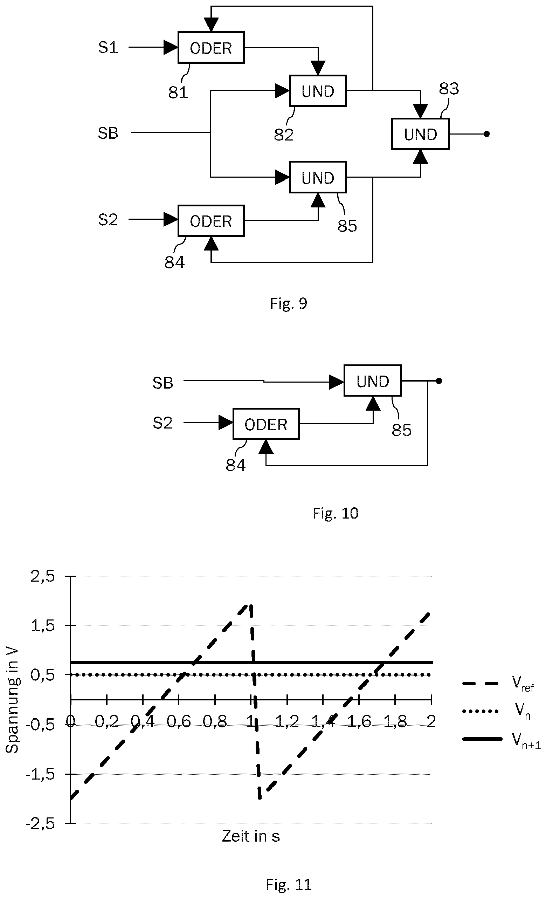

Der Spannungsverlauf, der vom Signalgenerator 11 erzeugten elektrischen Referenzspannung $V_{ref}$, entspricht einer vorgegebenen Kurve, wie beispielsweise der Kurve $V_{ref}$ in Figur 11. Erreicht oder übersteigt die elektrische Referenzspannung $V_{ref}$ einen der Spannungswerte $V_1$; $V_2$; $V_3$, so gibt der jeweilige Komparator 51; 52; 53 ein Signal S1; S2; S3 an die Spannungs-Ermittlungs-Einheit aus. Das Signal S1; S2; S3 kann in diesem Anwendungsbeispiel beispielsweise ein Interrupt Signal mit einer beispielsweisen Impulslänge von 2ms sein. Das Interrupt Signal wird über eine gemeinsame Signalleitung der Komparatoren an die Spannungs-Ermittlungs-Einheit 14 übermittelt. Es kann vorteilhaft sein, die Komparatoren dabei einseitig voneinander zu entkoppeln z.B. mittels Dioden 71, 72, 73 an den Ausgängen der Komparatoren.

Bei diesem Anwendungsbeispiel fließt ein konstanter Strom über die gemeinsame Signalleitung und es liegt eine konstante Spannung $V_{DD}$ an, erzeugt durch die Versorgungsspannung $V_{DD}$ und dem Widerstand R1. Ein Interrupt Signal erzeugt einen Kurzschluss zu Ground, sodass während des Interrupt Signals keine Spannung, bzw. kein Strom am Eingang der Spannungs-Ermittlungs-Einheit anliegt. Dies hat den Vorteil einer einfacheren Störungs- und Ausfalls-Detektion.

Die Spannungs-Ermittlungs-Einheit 14 berechnet basierend auf den Zeitpunkten, an denen entsprechende Interrupt Signale der Komparatoren ausgegeben werden, und dem vorgegebenen Kurvenverlauf der elektrischen Referenzspannung $V_{ref}$ die Werte der Spannungen $V_1$, $V_2$, $V_3$ und ordnet Sie den Elektroden entsprechend der zeitlichen Reihenfolge zu. Basierend auf den ermittelten Spannungswerten $V_1$, $V_2$, $V_3$ berechnet die Spannungs-Berechnungs-Einheit 15 die Zellspannungen der in Reihe geschalteten Batteriezellen Z1, Z2, Z3.

Diese Ausführungsform ist besonders kostensparend, insbesondere zur Ermittlung der Zellspannungen von Batterien mit einer großen Anzahl in Reihe geschalteter Zellen, da kein Analog-Digital-Umwandler benötigt wird und die Anzahl der mit dieser Ausführungsform ermittelbaren in Reihe geschalteter Zellen nicht durch die Anzahl an Signaleingängen der Spannungs-Ermittlungs-Einheit begrenzt ist.

Figur 8 zeigt einen möglichen Schaltungsentwurf einen Balancer RB nach Bestimmung einer Zellspannung Z3 parallel zur Zelle Z3 zu schalten. Dabei wird der Schalter 71 vom Schaltelement K1 gesteuert. Eine mögliche Ausführungsform des Schaltelements K1 ist in Figur 10 zu sehen. Der Balancer RB wird dabei bei Vorliegen der Signale SB und S2 aktiviert und bei Ausbleiben des Signals SB deaktiviert.

In Figur 9 wird eine beispielhafte Logik-Schaltung zum Aktivieren und Deaktivieren eines Balancers in Abhängigkeit eines Steuersignals SB und Signalen S1 und S2 gezeigt, die von zwei verschiedenen Komparatoren der Komparatoren 51, 52, 53 ausgegebene werden, siehe Figuren 5 und 7. Bei Vorliegen der Signale S1 und SB gibt eine UND - Schaltung 82 ein Signal an die UND-Schaltung 83 und an die ODER-Schaltung 81 aus. Die ODER-Schaltung gibt dieses Signal wiederum an die UND-Schaltung 82. Somit reicht ein einmaliges Signal S1, sodass ein Signal von der UND-Schaltung 82 an die UND-Schaltung 83 übermittelt wird, einzig das Signal SB muss dafür beständig anliegen.

Die ODER- und UND-Schaltungen 84 bzw. 85 ermöglichen eine Schaltung mittels der Signale S2 und SB analog zur Schaltung der Signale S1 und SB. Bei Vorliegen zweier Eingangssignale an der UND-Schaltung 83 ist der Balancer aktiviert. In anderen Worten der Balancer wird aktiviert, wenn das Signal SB vorliegt und mindestens jeweils ein Interrupt Signal vorliegt. Sind die Signale S1 und/oder S2 invertiert, wie zum Beispiel in Figur 7, so können Invertierer die Signale S1 und/oder S2 entsprechend umwandeln. Bleibt das Steuersignal SB aus wird der Balancer deaktiviert.

In Figur 10 wird eine weitere beispielhafte Logik-Schaltung zum Aktivieren und Deaktivieren eines Balancers RB gezeigt. Das Aktivieren und Deaktivieren des Balancers in dieser Ausführungsform ist nur von einem Steuersignal SB und einem Signal S2 abhängig, siehe Figur 8. Die Schaltung aus Figur 9 reduziert sich dabei auf die Schaltelemente 84 und 85, die in der gleichen Art und Weise wie in Figur 9 beschalten werden. Vorteil dieser Schaltung ist, dass die Anzahl der Schaltelemente reduziert wird.

Figur 11 zeigt einen möglichen Spannungsverlauf, der von einem Signalgenerator 11 erzeugt wird. Der Signalgenerator 11 kann hier in Form eines Integrierers realisiert sein. $V_n$ und $V_{n+1}$ sind jeweils Spannungen, die zwischen einem Referenzpotential P und zweier unterschiedlicher Elektroden einer m-ten Zelle anliegen.

BEZUGSZEICHEN

| | |
|---|---|
| $V_{ref}$ | elektrische Referenzspannung, die sich zeitlich verändert |
| P | Referenzpotential |
| $U_m$ | Zellspannung einer m-ten Zelle |
| $V_n$ | elektrische Spannung zwischen einem Referenzpotential P und einer Elektrode einer m-ten Zelle |
| $V_{n+1}$ | elektrische Spannung zwischen einem Referenzpotential P und einer weiter Elektrode einer m-ten Zelle |
| RB | Balancer |
| R1 | Widerstand |
| S1 | Signal |
| S2 | weiteres Signal |
| Z1, Z2, Z3, Z4 | Zellen |
| $U_0, U_1, U_2, U_3, U_4$ | Zellspannungen der Zellen Z1, Z2, Z3, bzw. Z4 |
| $V_0, V_1, V_2, V_3, V_4$ | elektrische Spannungen zwischen einem Referenzpotential P und Elektroden |
| $V_{DD}$ | Versorgungsspannung |
| SB | Steuersignal zur Aktivierung und Deaktivierung von Balancer |
| K1 | Schaltelement zum Aktivieren und Deaktivieren eines Balancers |
| 10 | System zum Ermitteln einer Zellspannung |
| 11 | Signalgenerator |
| 12, 13 | Komparator |

| 14 | Spannungs-Ermittlungs-Einheit |
| 15 | Spannungs-Berechnungs-Einheit |
| 41 | Multiplexer |
| 42 | Analog-Digital-Umwandler |
| 51, 52, 53 | Komparatoren |
| 71, 72, 73 | Dioden |
| 81, 84 | ODER-Gatter |
| 82, 83, 85 | UND-Gatter |

**Patentansprüche**

1. Verfahren zum Ermitteln des Wertes einer Zellspannung $U_m$ einer m-ten Zelle von in Reihe geschalteten Zellen umfassend die Schritte:

Bereitstellen einer elektrischen Referenzspannung $V_{ref}$, die sich über die Zeit verändert;
Vergleichen der elektrischen Referenzspannung $V_{ref}$ mit den elektrischen Spannungen $V_n$ und $V_{n+1}$;
Ausgeben von einem ersten Signal S1, wenn die elektrische Referenzspannung $V_{ref}$ wertmäßig den Wert der elektrischen Spannung $V_n$ erreicht;
Ermitteln des Wertes der elektrischen Spannung $V_n$ mittels des Signals S1;
Ausgeben von einem zweiten Signal S2, wenn die elektrische Referenzspannung $V_{ref}$ wertemäßig den Wert der elektrischen Spannung $V_{n+1}$ erreicht;
Ermitteln des Wertes der elektrischen Spannung $V_{n+1}$ mittels des Signals S2;
Berechnen der Zellspannung $U_m$ auf Basis folgender Gleichung:

$$U_m = V_{n+1} - V_n,$$

wobei eine elektrische Spannung $V_n$ zwischen einem Referenzpotential P und einer ersten Elektrode der m-ten Zelle anliegt und eine elektrische Spannung $V_{n+1}$ zwischen dem Referenzpotential P und einer zweiten Elektrode der m-ten Zelle anliegt,
**dadurch gekennzeichnet, dass**
die Signale S1 und S2 Interrupt Signale sind und über eine gemeinsame Signalleitung ausgegeben werden.

2. Verfahren nach Anspruch 1, wobei

- der zeitliche Verlauf der elektrischen Referenzspannung $V_{ref}$ einer vorgegebenen Funktion entspricht; und
- die zu ermittelnden Werte der elektrischen Spannungen $V_n$, und/oder $V_{n+1}$ auf Basis der vorgegebenen Funktion der elektrischen Referenzspannung $V_{ref}$ und der Zeitpunkte, zu denen die Signale S1 und/oder S2 ausgegeben werden, berechnet werden.

3. Verfahren nach Anspruch 2, wobei

- die zu ermittelnden Werte der elektrischen Spannungen $V_n$, und/oder $V_{n+1}$ durch Ermitteln der elektrischen Referenzspannung $V_{ref}$ mit einem Analog-Digital-Umwandler zu den Zeitpunkten, zu denen die Signale S1 und/oder S2 ausgegeben werden, bestimmt werden.

4. Verfahren nach Anspruch 2, wobei

- die elektrische Referenzspannung $V_{ref}$ mittels eines Digital-Analog-Umwandlers bereitgestellt wird; und
- die zu ermittelnden Werte der elektrischen Spannungen $V_n$, und/oder $V_{n+1}$ am Eingang des Digital-Analog-Umwandlers in digitaler Form zu den Zeitpunkten, zu denen die Signale S1 und/oder S2 ausgegeben werden, anliegen.

5. Verfahren nach einem der Ansprüche 2 bis 4 umfassend den Schritt:

- Aktivieren eines parallel zur m-ten Zelle geschalteten Balancers bei Vorliegen eines Steuersignals SB und der Signale S1 und/oder S2.

**6.** Verfahren nach einem der Ansprüche 2 bis 5 umfassend den Schritt:

- Deaktivieren eines parallel zur m-ten Zelle geschalteten Balancers bei Ausbleiben eines Steuersignals SB.

**7.** Ein System (10) zum Ermitteln einer Zellspannung umfassend:

- einen Signalgenerator (11) ausgebildet zum Bereitstellen einer elektrischen Referenzspannung $V_{ref}$, die sich über die Zeit verändert;
- zwei Komparatoren (12, 13) ausgebildet zum Vergleichen der elektrischen Referenzspannung $V_{ref}$ mit den elektrischen Spannungen $V_n$ und $V_{n+1}$, wobei ein erster Komparator (12) ausgebildet ist, ein erstes Signal S1 auszugeben, wenn die elektrische Referenzspannung $V_{ref}$ wertemäßig den Wert der elektrischen Spannung $V_n$ erreicht und ein zweiter Komparator (13) ausgebildet ist, ein zweites Signal S2 auszugeben, wenn die elektrische Referenzspannung $V_{ref}$ wertemäßig den Wert der elektrischen Spannung $V_{n+1}$ erreicht;
- eine Spannungs-Ermittlungs-Einheit (14) ausgebildet zum Ermitteln des Wertes der elektrischen Spannung $V_n$ mittels des Signals S1 und ausgebildet zum Ermitteln des Wertes der elektrischen Spannung $V_{n+1}$ mittels des Signals S2;
- eine Spannungs-Berechnungseinheit (15) ausgebildet zum Ermitteln eines Wertes einer Zellspannung $U_m$ einer m-ten Zelle von in Reihe geschalteten Zellen auf Basis folgender Gleichung: $U_m = V_{n+1} - V_n$, wobei die elektrische Spannung $V_n$ zwischen einem Referenzpotential P und einer ersten Elektrode der m-ten Zelle anliegt und die elektrische Spannung $V_{n+1}$ zwischen dem Referenzpotential P und einer zweiten Elektrode der m-ten Zelle anliegt,
**dadurch gekennzeichnet, dass**
die Signale S1 und S2 Interrupt Signale sind und über eine gemeinsame Signalleitung ausgegeben werden, wobei das System die gemeinsame Signalleitung umfasst.

**8.** System (10) nach Anspruch 7, wobei

- der zeitliche Verlauf der elektrischen Referenzspannung $V_{ref}$ einer vorgegebenen Funktion entspricht; und
- die zu ermittelnden Werte der elektrischen Spannungen $V_n$, und/oder $V_{n+1}$ auf Basis der vorgegebenen Funktion der elektrischen Referenzspannung $V_{ref}$ und der Zeitpunkte, zu denen die Signale S1 und/oder S2 ausgegeben werden, berechnet werden.

**9.** System (10) nach Anspruch 7, wobei

- die zu ermittelnden Werte der elektrischen Spannungen $V_n$, und/oder $V_{n+1}$ durch Ermitteln der elektrischen Referenzspannung $V_{ref}$ mittels eines Analog-Digital-Umwandlers (42) zu den Zeitpunkten, zu denen die Signale S1 und/oder S2 ausgegeben werden, bestimmt werden.

**10.** System (10) nach Anspruch 7, wobei

- die elektrische Referenzspannung $V_{ref}$ mittels eines Digital-Analog-Umwandlers bereitgestellt wird; und
- die zu ermittelnden Werte der elektrischen Spannungen $V_n$, und/oder $V_{n+1}$ am Eingang des Digital-Analog-Umwandlers in digitaler Form zu den Zeitpunkten, zu denen die Signale S1 und/oder S2 ausgegeben werden, anliegen.

**11.** System (10) nach einem der Ansprüche 7 bis 10 umfassend:

- einen parallel zur m-ten Zelle geschalteten Balancer, der bei Vorliegen eines Steuersignals SB und der Signale S1 und/oder S2 aktiviert und bei Ausbleiben des Steuersignals SB deaktiviert wird.

**12.** System (10) nach einem der Ansprüche 7 bis 11, wobei die Ausgänge mindestens zweier Komparatoren (12, 13) über eine Signalleitung mit der Spannungs-Ermittlungs-Einheit verbunden sind.

**13.** System (10) nach Anspruch 12, wobei die Spannungs-Ermittlungs-Einheit (14) die Signale S1 und/oder S2 basierend auf der zeitlichen Reihenfolge, in der die Signale S1 und S2 ausgegeben werden, den Elektroden der Zellen zuordnet.

**14.** System (10) nach Anspruch 12, wobei
die Signale S1 und/oder S2 codiert sind; und
die Spannungs-Ermittlungs-Einheit (14) die Signale S1 und/oder S2 anhand der Codierung den Elektroden der Zellen zuordnet.

**15.** System (10) nach Anspruch 12, wobei
der zeitliche Verlauf der elektrischen Referenzspannung $V_{ref}$ einer monoton steigenden oder monoton fallenden Funktion entspricht; und
die Spannungs-Ermittlungs-Einheit (14) die Signale S1 und/oder S2 anhand der elektrischen Spannungswerte $V_n$ und/oder $V_{n+1}$ den Elektroden der Zellen zuordnet.

**Claims**

**1.** A method for determining the value of a cell voltage $U_m$ of an m-th cell of series-connected cells, comprising the steps of:

providing an electrical reference voltage $V_{ref}$ changing over time;
comparing the electrical reference voltage $V_{ref}$ with the electrical voltages $V_n$ and $V_{n+1}$;
outputting a first signal S1 when the electrical reference voltage $V_{ref}$ reaches the value of the electrical voltage $V_n$ in terms of value;
determining the value of the electrical voltage $V_n$ by means of the signal S1;
outputting a second signal S2 when the electrical reference voltage $V_{ref}$ reaches the value of the electrical voltage $V_{n+1}$ in terms of value;
determining the value of the electrical voltage $V_{n+1}$ by means of the signal S2;
calculating the cell voltage $U_m$ based on the following equation:

$$U_m = V_{n+1} - V_n,$$

wherein an electrical voltage $V_n$ is applied between a reference potential P and a first electrode of the m-th cell and an electrical voltage $V_{n+1}$ is applied between the reference potential P and a second electrode of the m-th cell **characterized in that**
the signals S1 and/or S2 are interrupt signals and are output via a common signal line.

**2.** The method according to claim 1, wherein

- the time profile of the electrical reference voltage $V_{ref}$ corresponds to a predetermined function; and
- the values of the electrical voltages $V_n$ and/or $V_{n+1}$ to be determined are calculated based on the predetermined function of the electrical reference voltage $V_{ref}$ and the times at which the signals S1 and/or S2 are output.

**3.** The method according to claim 2 wherein

- the values of the electrical voltages $V_n$ and/or $V_{n+1}$ to be determined are determined by determining the electrical reference voltage $V_{ref}$ with an analog-to-digital converter at the times at which the signals S1 and/or S2 are output.

**4.** The method of claim 2, wherein

- the electrical reference voltage $V_{ref}$ is provided by means of a digital-to-analog converter; and
- the values of the electrical voltages $V_n$ and/or $V_{n+1}$ to be determined are applied to the input of said digital-to-analog converter in digital form at the times at which the signals S1 and/or S2 are output.

**5.** The method according to one of claims 2 to 4, comprising the step of:

- activating a balancer connected in parallel to the m-th cell when a control signal SB and the signals S1 and/or S2 are present.

6. The method according to one of claims 2 to 5 comprising the step of:
deactivating a balancer connected in parallel to the m-th cell when a control signal SB is absent.

7. A system (10) for determining a cell voltage, comprising:

- a signal generator (11) configured to provide an electrical reference voltage $V_{ref}$, which changes over time;
- two comparators (12, 13) configured to compare the electrical reference voltage $V_{ref}$ with the electrical voltages $V_n$ and $V_{n+1}$, wherein

a first comparator (12) is configured to output a first signal S1 when the electrical reference voltage $V_{ref}$ reaches the value of the electrical voltage $V_n$ in terms of value, and
a second comparator (13) is configured to output a second signal S2 when the electrical reference voltage $V_{ref}$ reaches the value of the electrical voltage $V_{n+1}$ in terms of value;

- a voltage determination unit (14) configured to determine the value of the electrical voltage $V_n$ by means of the signal S1 and to determine the value of the electrical voltage $V_{n+1}$ by means of the signal S2;
- a voltage calculation unit configured to determine a value of a cell voltage $U_m$ of an m-th cell of series-connected cells based on the following equation:

$$U_m = V_{n+1} - V_n,$$

wherein an electrical voltage $V_n$ is applied between a reference potential P and a first electrode of the m-th cell and an electrical voltage $V_{n+1}$ is applied between the reference potential P and a second electrode of the m-th cell, **characterized in that**
the signals S1 and/or S2 are interrupt signals and are output via a common signal line, said system comprising said common signal line.

8. The system (10) according to claim 7, wherein

- the time profile of the electrical reference voltage $V_{ref}$ corresponds to a predetermined function; and
- the values of the electrical voltages $V_n$ and/or $V_{n+1}$ to be determined are calculated based on the predetermined function of the electrical reference voltage $V_{ref}$ and the times at which the signals S1 and/or S2 are output.

9. The system (10) according to claim 7, wherein

- the values of the electrical voltages $V_n$ and/or $V_{n+1}$ to be determined are determined by determining the electrical reference voltage $V_{ref}$ by means of an analog-to-digital converter (42) at the times at which the signals S1 and/or S2 are output.

10. The system (10) according to claim 7, wherein

- the electrical reference voltage $V_{ref}$ is provided by means of a digital-to-analog converter; and
- the values of the electrical voltages $V_n$ and/or $V_{n+1}$ to be determined are applied to the input of said digital-to-analog converter in digital form at the times at which the signals S1 and/or S2 are output.

11. The system (10) according to one of claims 7 to 10, comprising:

- a balancer which is connected in parallel to the m-th cell and which is activated when a control signal SB and the signals S1 and/or S2 are present and deactivated when the control signal SB is absent.

12. The system (10) according to one of claims 7 to 11, wherein
the outputs of at least two comparators (12, 13) are connected to the voltage determination unit via a signal line.

13. The system (10) according to claim 12, wherein
said voltage determination unit (14) assigns the signals S1 and/or S2 to the electrodes of the cells based on the chronological order in which the signals S1 and S2 are output.

**14.** The system (10) according to claim 12, wherein

the signals S1 and / or S2 are coded; and
said voltage determination unit (14) assigns the signals S1 and/or S2 to the electrodes of the cells based on the coding.

**15.** The system (10) according to claim 12, wherein

the time profile of the electrical reference voltage $V_{ref}$ corresponds to a monotonically increasing or monotonically decreasing function; and
said voltage determination unit (14) assigns the signals S1 and/or S2 to the electrodes of the cells based on the electrical voltage values $V_n$ and/or $V_{n+1}$.

**Revendications**

**1.** Procédé pour déterminer la valeur d'une tension de cellule $U_m$ d'une m-ième cellule de cellules montées en série comprenant les étapes :

de fourniture d'une tension de référence électrique $V_{ref}$, qui change dans le temps ;
de comparaison de la tension de référence électrique $V_{ref}$ aux tensions électriques $V_n$ et $V_{n+1}$ ;
d'émission d'un premier signal S1, lorsque la tension de référence électrique $V_{ref}$ atteint en valeur la valeur de la tension électrique $V_n$ ;
de détermination de la valeur de la tension électrique $V_n$ au moyen du signal S1 ;
d'émission d'un deuxième signal S2, lorsque la tension de référence électrique $V_{ref}$ atteint en valeur la valeur de la tension électrique $V_{n+1}$ ;
de détermination de la valeur de la tension électrique $V_{n+1}$ au moyen du signal S2 ;
de calcul de la tension de cellule $U_m$ sur la base de l'équation suivante :

$$U_m = V_{n+1} - V_n,$$

dans lequel une tension électrique $V_n$ s'applique entre un potentiel de référence P et une première électrode de la m-ième cellule et une tension électrique $V_{n+1}$ entre le potentiel de référence P et une deuxième électrode de la m-ième cellule,
**caractérisé en ce que**
les signaux S1 et S2 sont des signaux d'interruption et sont émis par l'intermédiaire d'une ligne de signalisation commune.

**2.** Procédé selon la revendication 1, dans lequel

- la variation dans le temps de la tension de référence électrique $V_{ref}$ correspond à une fonction prédéfinie ; et
- les valeurs à déterminer des tensions électriques $V_n$ et/ou $V_{n+1}$ sont calculées sur la base de la fonction prédéfinie de la tension de référence électrique $V_{ref}$ et des moments auxquels les signaux S1 et/ou S2 sont émis.

**3.** Procédé selon la revendication 2, dans lequel

- les valeurs à déterminer des tensions électriques $V_n$ et/ou $V_{n+1}$ sont définies par détermination de la tension de référence électrique $V_{ref}$ avec un convertisseur analogique-numérique aux moments auxquels les signaux S1 et/ou S2 sont émis.

**4.** Procédé selon la revendication 2, dans lequel

- la tension de référence électrique $V_{ref}$ est fournie au moyen d'un convertisseur analogique-numérique ; et
- les valeurs à déterminer des tensions électriques $V_n$ et/ou $V_{n+1}$ s'appliquent à l'entrée du convertisseur analogique-numérique sous forme numérique aux moments auxquels les signaux S1 et/ou S2 sont émis.

**5.** Procédé selon l'une quelconque des revendications 2 à 4 comprenant l'étape :

- d'activation d'un dispositif d'équilibrage monté parallèlement à la m-ième cellule en présence d'un signal de commande SB et des signaux S1 et/ou S2.

6. Procédé selon l'une quelconque des revendications 2 à 5 comprenant l'étape :

- de désactivation d'un dispositif d'équilibrage monté parallèlement à la m-ième cellule en l'absence d'un signal de commande SB.

7. Système (10) pour déterminer une tension de cellule comprenant :

- un générateur de signal (11) réalisé pour fournir une tension de référence électrique $V_{ref}$, qui change dans le temps ;
- deux comparateurs (12, 13) réalisés pour comparer la tension de référence électrique $V_{ref}$ aux tensions électriques $V_n$ et $V_{n+1}$, dans lequel
un premier comparateur (12) est réalisé pour émettre un premier signal S1, lorsque la tension de référence électrique $V_{ref}$ atteint en valeur la valeur de la tension électrique $V_n$ et un deuxième comparateur (13) est réalisé pour émettre un deuxième signal S2, lorsque la tension de référence électrique $V_{ref}$ atteint en valeur la valeur de la tension électrique $V_{n+1}$ ;
- une unité de détermination de tension (14) réalisée pour déterminer une valeur de la tension électrique $V_n$ au moyen du signal S1 et réalisée pour déterminer la valeur de la tension électrique $V_{n+1}$ au moyen du signal S2 ;
- une unité de calcul de tension (15) réalisée pour déterminer la valeur d'une tension de cellule $U_m$ d'une m-ième cellule de cellules montées en série sur la base de l'équation suivante : $U_m = V_{n+1} - V_n$,
dans lequel la tension électrique $V_n$ s'applique entre un potentiel de référence P et une première électrode de la m-ième cellule et la tension électrique $V_{n+1}$ entre le potentiel de référence P et une deuxième électrode de la m-ième cellule,
**caractérisé en ce que**
les signaux S1 et S2 sont des signaux d'interruption et sont émis par l'intermédiaire d'une ligne de signalisation commune, dans lequel le système comprend la ligne de signalisation commune.

8. Système (10) selon la revendication 7, dans lequel

- la variation dans le temps de la tension de référence électrique $V_{ref}$ correspond à une fonction prédéfinie ; et
- les valeurs à déterminer des tensions électriques $V_n$ et/ou $V_{n+1}$ sont calculées sur la base de la fonction prédéfinie de la tension de référence électrique $V_{ref}$ et des moments auxquels les signaux S1 et/ou S2 sont émis.

9. Système (10) selon la revendication 7, dans lequel

- les valeurs à déterminer des tensions électriques $V_n$ et/ou $V_{n+1}$ sont définies par détermination de la tension de référence électrique $V_{ref}$ au moyen d'un convertisseur analogique-numérique (42) aux moments auxquels les signaux S1 et/ou S2 sont émis.

10. Système (10) selon la revendication 7, dans lequel

- la tension de référence électrique $V_{ref}$ est fournie au moyen d'un convertisseur analogique-numérique ; et
- les valeurs à déterminer des tensions électriques $V_n$ et/ou $V_{n+1}$ s'appliquent à l'entrée du convertisseur analogique-numérique sous forme numérique aux moments auxquels les signaux S1 et/ou S2 sont émis.

11. Système (10) selon l'une quelconque des revendications 7 à 10, comprenant :

- un dispositif d'équilibrage monté parallèlement à la m-ième cellule, qui est activé en présence d'un signal de commande SB et des signaux S1 et/ou S2 et désactivé en l'absence du signal de commande SB.

12. Système (10) selon l'une quelconque des revendications 7 à 11, dans lequel
les sorties au moins de deuxièmes comparateurs (12, 13) sont reliées à l'unité de détermination de tension par l'intermédiaire d'une ligne de signalisation.

13. Système (10) selon la revendication 12, dans lequel
l'unité de détermination de tension (14) associe les signaux S1 et/ou S2 aux électrodes des cellules sur la base de l'ordre chronologique dans lequel les signaux S1 et S2 sont émis.

**14.** Système (10) selon la revendication 12, dans lequel

les signaux S1 et/ou S2 sont codés ; et
l'unité de détermination de tension (14) associe les signaux S1 et/ou S2 aux électrodes des cellules sur la base du codage.

**15.** Système (10) selon la revendication 12, dans lequel

la variation dans le temps de la tension de référence électrique $V_{ref}$ correspond à une fonction à croissance monotone ou à décroissance monotone ; et
l'unité de détermination de tension (14) associe les signaux S1 et/ou S2 aux électrodes des cellules sur la base des valeurs de tension électriques $V_n$ et/ou $V_{n+1}$.

Fig. 1

Fig. 2

Fig. 3

Fig. 4

Fig. 5

S21 — Referenzspannung $V_{ref}$ ausgeben

Referenzspannung $V_{ref}$ mit Spannung $V_n$ vergleichen

S22a

Referenzspannung $V_{ref}$ mit Spannung $V_{n+1}$ vergleichen

S22b

Wert von $V_{ref}$ erreicht Wert von $V_n$ — nein

S23a

Wert von $V_{ref}$ erreicht Wert von $V_{n+1}$ — nein

S23b

ja

Wert von $V_n$ ermitteln

S24a

ja

Wert von $V_{n+1}$ ermitteln

S24b

Steuersignal SB liegt vor

S26

Werte von $V_n$ und $V_{n+1}$ sind ermittelt — nein

S25

ja

Balancer RB aktivieren

S27

ja

Zellspannung $U_m = V_{n+1} - V_n$ berechnen

S200

Fig. 6

Fig. 7

Fig. 8

Fig. 9

Fig. 10

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9407153 A1
- DE 102013012148 A1
- US 2014043031 A1